# EUROPEAN PATENT APPLICATION

(11) **EP 4 571 749 A1**
(43) Date of publication of application: **18.06.2025**
(21) Application number: 24210837.1
(22) Date of filing: 05.11.2024
(51) Int. Cl.: G11C 5/14

(54) **STORAGE DEVICE DETECTING ERROR IN POWER-ON-RESET SIGNAL, AND OPERATING METHOD THEREOF**

(30) Priority: 22.11.2023 KR 20230163767; 23.02.2024 KR 20240026457; 16.08.2024 US 202418807266
(71) Applicant: Samsung Electronics Co., Ltd., Suwon-si, Gyeonggi-do 16677 (KR)
(72) Inventor: KIM, Myeonghun, 16677 Suwon-si (KR); PARK, Taesun, 16677 Suwon-si (KR); NAM, Suckhyun, 16677 Suwon-si (KR); PARK, Iksung, 16677 Suwon-si (KR); EUN, Hyunglae, 16677 Suwon-si (KR)
(74) Representative: Marks & Clerk LLP

(57) **Abstract**

Disclosed is a storage device which includes a memory device, a power supply port that receives a first external power voltage from a host device, a power supply circuit that receives the first external power voltage from the power supply port and generates a first internal power voltage based on the first external power voltage, a monitoring circuit that receives the first external power voltage from the power supply port and generates a first power-on-reset signal based on monitoring the first external power voltage, and a storage controller configured to control the memory device. The storage controller is driven based on the first internal power voltage and the first power-on-reset signal, and the monitoring circuit detects a voltage drop in the first power-on-reset signal transmitted from the monitoring circuit to the storage controller and provides an error detection signal to the storage controller in response to detecting the voltage drop.

## Description

### BACKGROUND

Embodiments of the present disclosure described herein relate to a storage device, and more particularly, relate to a storage device detecting an error in a power-on-reset signal and an operating method thereof.

A host may control an overall operation of a storage device. The host may exchange data with the storage device and may also supply a power to the storage device. In the storage device, a storage controller which controls a memory device is driven based on the power from the host.

However, when an error occurs in the process of supplying the power to the storage controller, the storage controller is immediately shut down. In this case, it is impossible to specify a shut-down cause of the storage controller.

### SUMMARY

Embodiments of the present disclosure provide a storage device detecting an error in a power-on-reset signal and an operating method thereof.

Provided herein is a storage device including a memory device; a power supply port configured to receive a first external power voltage from a host device; a power supply circuit configured to: receive the first external power voltage from the power supply port, and generate a first internal power voltage based on the first external power voltage; a monitoring circuit configured to: receive the first external power voltage from the power supply port, and generate a first power-on-reset signal based on monitoring the first external power voltage; and a storage controller configured to control the memory device, wherein the storage controller is driven based on the first internal power voltage and the first power-on-reset signal, and wherein the monitoring circuit is further configured to: detect a voltage drop in the first power-on-reset signal transmitted from the monitoring circuit to the storage controller, and provide an error detection signal to the storage controller in response to detecting the voltage drop, whereby a shut-down cause of the storage controller can be detected, and wherein the voltage drop is the shut-down cause of the storage controller.

Also provided is a method performed by the storage device, wherein the storage device includes a memory device, a power supply port, a power supply circuit, a storage controller, and a monitoring circuit, the method including: receiving, by the power supply port, a first external power voltage from a host device; generating, by the power supply circuit, a first internal power voltage based on the first external power voltage; generating, by the monitoring circuit, a first power-on-reset signal based on monitoring the first external power voltage; detecting, by the monitoring circuit, a voltage drop in the first power-on-reset signal transmitted from the monitoring circuit to the storage controller; and providing, by the monitoring circuit, an error detection signal to the storage controller in response to detecting the voltage drop, whereby a shut-down cause of the storage controller can be detected, the voltage drop is the shut-down cause of the storage controller, and the error detection signal corresponds to the shut-down cause.

Additionally, provided herein is a storage device including a memory device; a power supply port configured to receive a first external power voltage from a host device; a communication port configured to communicate with the host device; a power supply circuit configured to receive the first external power voltage from the power supply port and to generate a first internal power voltage based on the first external power voltage; a monitoring circuit configured to receive the first external power voltage from the power supply port and to generate a first power-on-reset signal based on monitoring the first external power voltage; a storage controller, wherein the storage controller is driven based on the first internal power voltage and the first power-on-reset signal; and a micro controller unit (MCU) configured to communicate with the host device by using the communication port, wherein the monitoring circuit is configured to: detect a voltage drop in the first power-on-reset signal transmitted from the monitoring circuit to the storage controller, and provide an error detection signal to the storage controller in response to detecting the voltage drop, wherein the storage controller is further configured to log error detection information based on the error detection signal, whereby a shut-down cause of the storage controller can be detected, and wherein the voltage drop is the shut-down cause of the storage controller, and wherein the MCU is further configured to provide the error detection information received from the storage controller to the communication port.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram of a storage system according to an embodiment of the present disclosure.
FIG. 2 is a diagram illustrating a storage system of FIG. 1 in detail.
FIG. 3 is a block diagram of a storage device according to some embodiments of the present disclosure.
FIG. 4 is a diagram illustrating a monitoring circuit of FIG. 3 in detail.
FIG. 5 is a timing diagram describing a monitoring signal and an error detection signal according to some embodiments of the present disclosure.
FIG. 6 is a table describing a monitoring signal according to some embodiments of the present disclosure.
FIG. 7 is a flowchart of an operating method of a storage device according to an embodiment of the present disclosure.
FIG. 8 is a flowchart of an operating method of a storage device according to some embodiments of the present disclosure.
FIG. 9 is a flowchart describing an operating method of a storage controller after the storage controller is shut down, according to some embodiments of the present disclosure.
FIG. 10 is a block diagram of a storage system according to some embodiments of the present disclosure.
FIG. 11 is a diagram describing an operating method of a storage device after a storage controller of FIG. 10 is again driven.

### DETAILED DESCRIPTION

Below, embodiments of the present disclosure will be described in detail and clearly to such an extent that one skilled in the art carries out embodiments of the present disclosure easily.

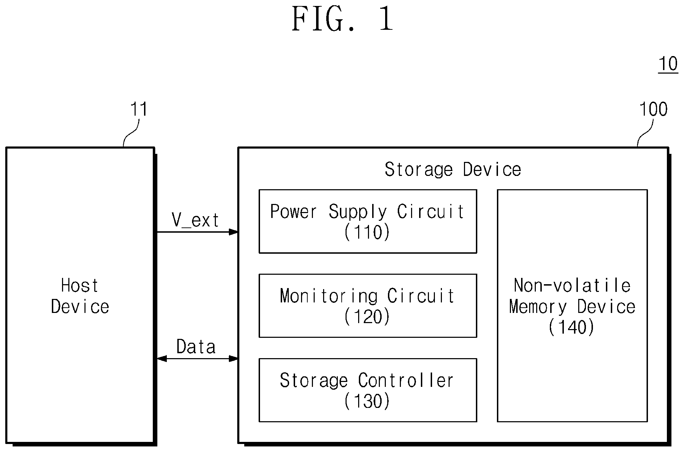

FIG. 1 is a block diagram of a storage system according to an embodiment of the present disclosure. Referring to FIG. 1, a storage system 10 may include a host device 11 and a storage device 100. The storage system 10 may refer to a computing system, which is configured to process a variety of information, such as a personal computer (PC), a notebook, a laptop, a server, a workstation, a tablet PC, a smartphone, a digital camera, and a black box.

The host device 11 may provide an external power voltage V_ext to the storage device 100. The external power voltage V_ext may indicate at least one of various power voltages for driving the storage device 100. The host device 11 may exchange data with the storage device 100. For example, the host device 11 may provide the storage device 100 with data to be stored in the storage device 100 or may be provided with data present in the storage device 100 from the storage device 100.

The storage device 100 may include a power supply circuit 110, a monitoring circuit 120, a storage controller 130, and a non-volatile memory device 140.

The power supply circuit 110 may generate an internal power voltage based on the external power voltage V_ext received from the host device 11. The internal power voltage may indicate at least one of various power voltages for driving the storage controller 130. For example, the power supply circuit 110 may generate the internal power voltage with a second power voltage level by converting the external power voltage V_ext with a first power voltage level. The second power voltage level may be different from the first power voltage level. The power supply circuit 110 may provide the internal power voltage to the storage controller 130.

The monitoring circuit 120 may generate a power-on-reset signal based on the monitoring of the external power voltage V_ext. The power-on-reset signal may refer to a signal which allows the storage controller 130 to be driven based on the internal power voltage.

In some embodiments, when the power voltage level of the external power voltage V_ext exceeds a reference voltage level, the monitoring circuit 120 may generate the power-on-reset signal with a first logical value. The reference voltage level may be determined in advance based on various voltage levels necessary to drive the storage controller 130. In contrast, when the power voltage level of the external power voltage V_ext does not exceed the reference voltage level, the monitoring circuit 120 may generate the power-on-reset signal with a second logical value. Each of the first logical value and the second logical value may be one of "0" and "1", and the first logical value and the second logical value may be different from each other. A signal with a logical value of "0" may be a low-level signal, and a signal with a logical value of "1" may be a high-level signal.

The storage controller 130 may be driven based on the internal power voltage and the power-on-reset signal.

For example, when the internal power voltage is received from the power supply circuit 110 and the power-on-reset signal with the first logical value is received from the monitoring circuit 120, the storage controller 130 may be powered on. As another example, even though the internal power voltage is received from the power supply circuit 110, when the power-on-reset signal with the second logical value is received from the monitoring circuit 120, the storage controller 130 may not be powered on or may be powered off in the case of being already powered on.

The non-volatile memory device 140 may store data. The non-volatile memory device 140 may operate under control of the storage controller 130. For example, the storage controller 130 may store data in the non-volatile memory device 140 or may read data stored in the non-volatile memory device 140.

In some embodiments, the non-volatile memory device 140 may be a NAND flash memory device, but the present disclosure is not limited thereto. For example, the non-volatile memory device 140 may be one of various storage devices, which retain data stored therein even when a power is turned off, such as a phase-change random access memory (PRAM), a magnetic random access memory (MRAM), a resistive random access memory (RRAM), and a ferroelectric random access memory (FRAM).

The monitoring circuit 120 may detect a voltage drop in the power-on-reset signal transferred (e.g. transmitted) from the monitoring circuit 120 to the storage controller 130. Even though the power-on-reset signal with the first logical value is output from the monitoring circuit 120, the power-on-reset signal transferred to the storage controller 130 may have the second logical value. For example, even though the monitoring circuit 120 outputs the power-on-reset signal of the high level, an error (i.e., a voltage drop) in which the storage controller 130 receives the power-on-reset signal with the low level may occur. The monitoring circuit 120 is configured to allow detection of a shut-down cause of the storage controller 130. For example, the voltage drop may be a shut-down cause of the storage controller 130.

In some embodiments, the voltage drop in the power-on-reset signal may be caused by at least one of an interference by an adjacent electrical element, a high temperature, and a physical impact on a transmission line through which the power-on-reset signal is transferred from the monitoring circuit 120 to the storage controller 130.

The monitoring circuit 120 may determine whether the voltage drop in the power-on-reset signal occurs, by comparing an electrical signal of an output terminal of the monitoring circuit 120, through which the power-on-reset signal is output, and an electrical signal of an input terminal of the storage controller 130, through which the power-on-reset signal is input. The first electrical signal may correspond to the power-on-reset signal of the output terminal of the monitoring circuit 120. The second electrical signal may correspond to the power-on-reset signal of the input terminal of the storage controller 130.

In some embodiments, the monitoring circuit 120 may determine whether the first electrical signal is the same as the second electrical signal. For example, the monitoring circuit 120 may generate a monitoring signal with a fifth logical value, based on determining that a third logical value of the first electrical signal is the same as a fourth logical value of the second electrical signal. In contrast, the monitoring circuit 120 may generate a monitoring signal with a sixth logical value, based on determining that the third logical value is different from the fourth logical value. In an embodiment, each of the third to sixth logical values may be one of "0" and " 1", and the fifth logical value and the sixth logical value may be different from each other.

The monitoring circuit 120 may provide an error detection signal to the storage controller 130 in response to detecting the voltage drop in the power-on-reset signal. The error detection signal may indicate whether an error occurs in the power-on-reset signal.

For example, the monitoring circuit 120 may generate the error detection signal with a seventh logical value, based on determining that the voltage drop in the power-on-reset signal occurs. In contrast, the monitoring circuit 120 may generate the error detection signal with an eighth logical value, based on determining that the voltage drop in the power-on-reset signal does not occur. Each of the seventh logical value and the eighth logical value may be one of "0" and "1", and the seventh logical value and the eighth logical value may be different from each other.

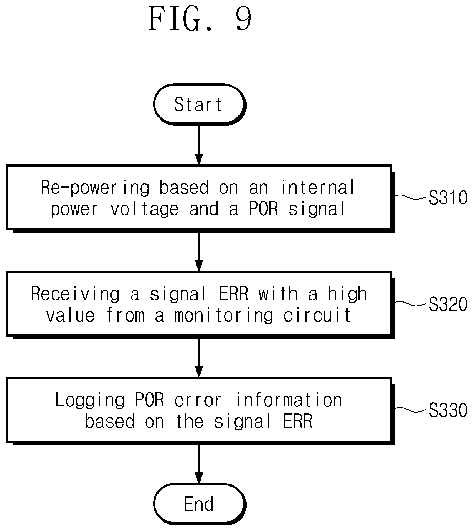

When the storage controller 130 is again driven by the internal power voltage and the power-on-reset signal after shut down by the voltage drop in the power-on-reset signal, the storage controller 130 may log error detection information based on the error detection signal received from the monitoring circuit 120. The error detection information may indicate information corresponding to the error occurrence in the power-on-reset signal. Thus, the error detection information can indicate a shut-down cause of the storage controller is a voltage drop in the power-on-reset signal. This will be described in detail with reference to FIG. 9.

When the voltage drop in the power-on-reset signal occurs, a conventional storage device may be shut down in a state of failing to log any information about the voltage drop.

The storage device according to the present disclosure may provide the error detection signal to the storage controller 130 in response to detecting that the monitoring circuit 120 providing the power-on-reset signal to the storage controller 130 detects the voltage drop in the power-on-reset signal. Accordingly, the storage device 100 may log the error detection information corresponding to the voltage drop in the power-on-reset signal. In addition, the storage device 100 may provide the error detection information to the host device 11 depending on a request, or the storage controller 130 may debug the error based on the error detection information. In one example, when an error occurs in the power-on-reset signal controlling the power supply to the storage controller 130, even though the storage controller 130 is shut down, the notification indicating that the error occurs in the power-on-reset signal may be provided from outside of (e.g. external to) the storage controller 130 to the storage controller 130, for example, by the monitoring circuit 120. Accordingly, a storage device capable of detecting an error in a power-on-reset signal is provided.

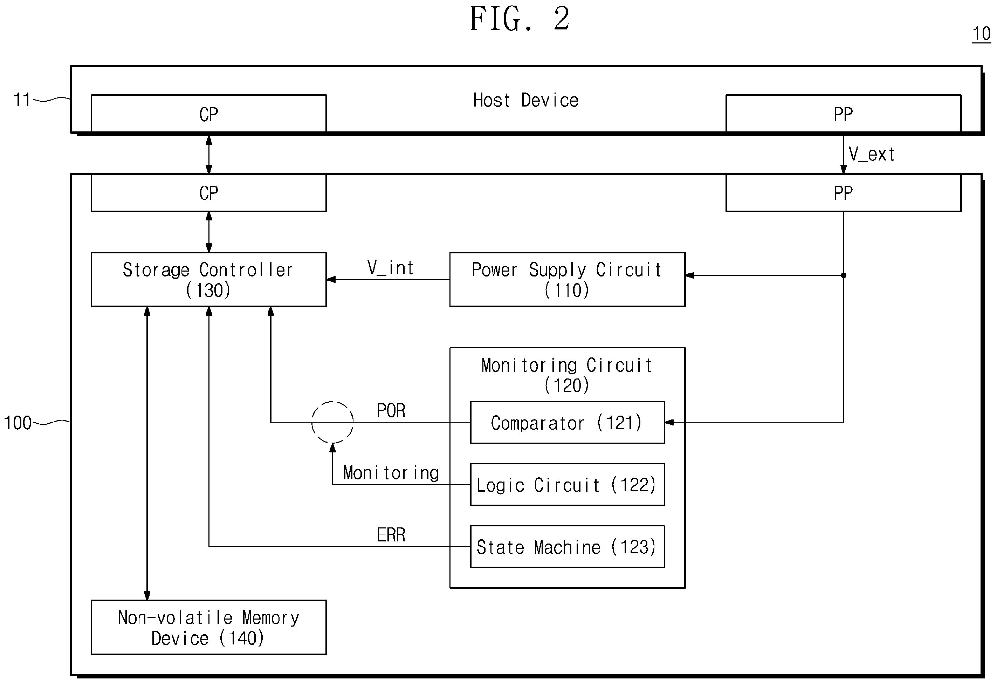

FIG. 2 is a diagram illustrating the storage system 10 of FIG. 1 in detail. Referring to FIG. 2, the host device 11 of the storage system 10 may include a communication port CP and a power supply port PP, and the storage device 100 of the storage system 10 may include a communication port CP, a power supply port PP, the power supply circuit 110, the monitoring circuit 120, the storage controller 130, and the non-volatile memory device 140.

The host device 11 and the storage device 100 may communicate with each other through the communication ports CP. For example, the host device 11 may exchange data with the storage controller 130 through the communication port CP. For example, the communication port CP may use an in-band channel. The communication port CP may be a peripheral component interconnect express (PCIe) port.

The host device 11 may provide the external power voltage V ext to the storage device 100 through the power supply port PP. The power supply port PP of the storage device 100 may receive the external power voltage V_ext from the host device 11. For example, the power supply port PP may use an out-of-band channel.

The power supply circuit 110 may provide the storage controller 130 with an internal power voltage V_int generated based on the external power voltage V_ext.

The monitoring circuit 120 may include a comparator 121, a logic circuit 122, and a state machine 123.

The comparator 121 may receive the external power voltage V_ext from the power supply port PP. The comparator 121 may generate a power-on-reset signal POR based on the monitoring of the external power voltage V_ext.

In some embodiments, the comparator 121 may generate the power-on-reset signal POR with the first logical value based on determining that the power voltage level of the external power voltage V_ext exceeds the reference voltage level.

The logic circuit 122 may detect the voltage drop in the power-on-reset signal POR transmitted from the comparator 121 to the storage controller 130.

In some embodiments, the logic circuit 122 may determine whether the voltage drop in the power-on-reset signal POR occurs, based on a comparison operation of the power-on-reset signal of the output terminal of the comparator 121 and the power-on-reset signal of the input terminal of the storage controller 130.

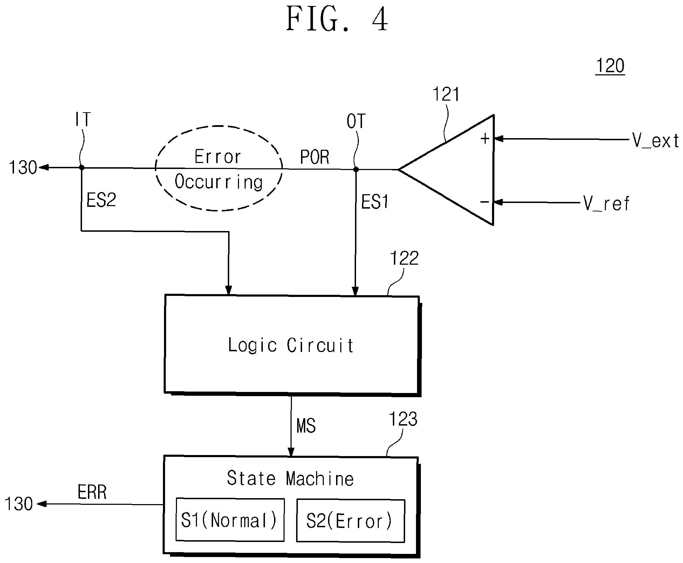

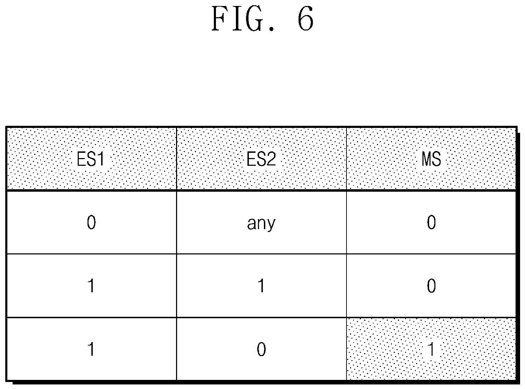

For example, when the logic circuit 122 detects the voltage drop in the power-on-reset signal POR, the logic circuit 122 may generate the monitoring signal with the sixth logical value. This will be described in detail with reference to FIGS. 4 and 6.

The state machine 123 may generate an error detection signal ERR in response to detecting the voltage drop in the power-on-reset signal POR. For example, the state machine 123 may provide the error detection signal ERR with the seventh logical value to the storage controller 130 based on the monitoring signal with the sixth logical value. In contrast, the state machine 123 may provide the error detection signal ERR with the eighth logical value to the storage controller 130 based on the monitoring signal with the fifth logical value. Each of the seventh logical value and the eighth logical value may be one of "0" and "1", and the seventh logical value and the eighth logical value may be different from each other.

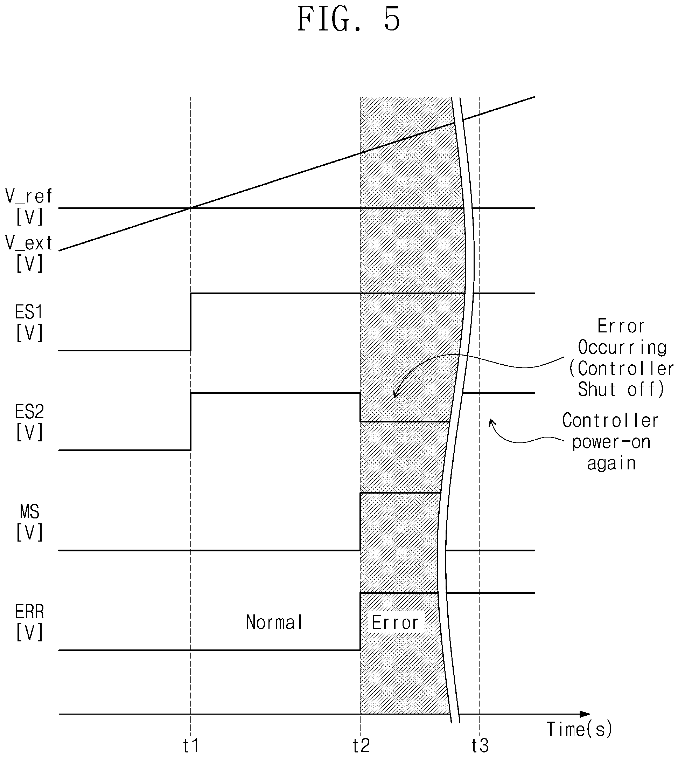

Afterwards, even though the logical value of the monitoring signal changes from the sixth logical value to the fifth logical value (e.g., even though the error does not exist in the power-on-reset signal POR), the state machine 123 may continuously provide the error detection signal ERR with the seventh logical value to the storage controller 130 until a separate signal is received from the storage controller 130. This will be described in detail with reference to FIGS. 4 and 5.

The storage controller 130 may be driven based on the internal power voltage V_int and the power-on-reset signal POR. The storage controller 130 may communicate with the non-volatile memory device 140.

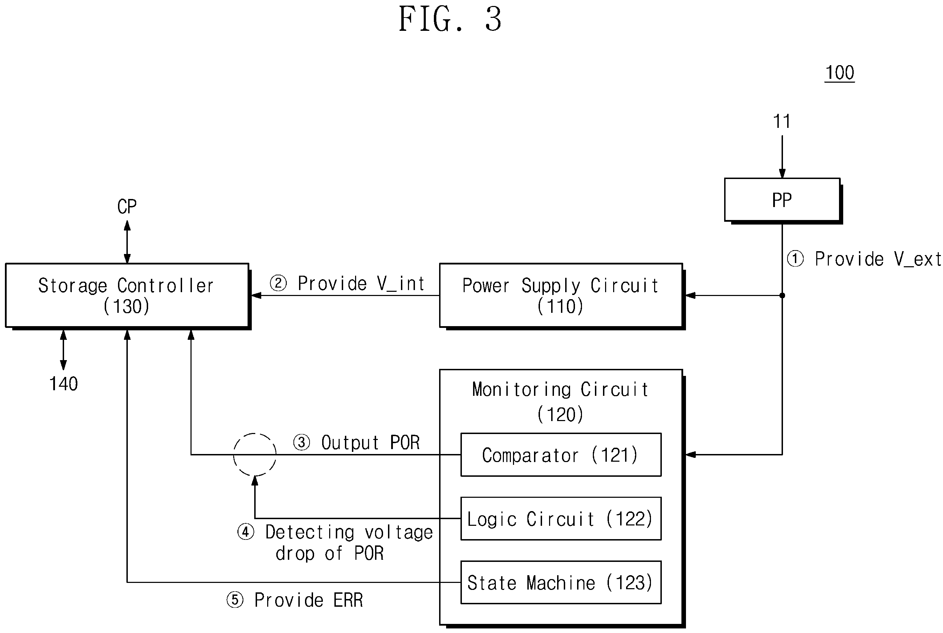

FIG. 3 is a block diagram of a storage device according to some embodiments of the present disclosure. Referring to FIGS. 2 and 3, the storage device 100 may include the power supply port PP, the power supply circuit 110, the monitoring circuit 120, and the storage controller 130.

The power supply port PP may receive the external power voltage V_ext from the host device 11 of FIG. 2. The power supply circuit 110 may receive the external power voltage V_ext from the power supply port PP and may generate the internal power voltage V_int based on the external power voltage V_ext.

The monitoring circuit 120 may include the comparator 121, the logic circuit 122, and the state machine 123. The comparator 121 may provide the power-on-reset signal POR to the storage controller 130 based on the monitoring of the external power voltage V_ext. The logic circuit 122 may detect the voltage drop in the power-on-reset signal POR to generate the monitoring signal. The state machine 123 may generate the error detection signal ERR based on the monitoring signal and may provide the error detection signal ERR to the storage controller 130.

The storage controller 130 may communicate with the host device 11 through the communication port CP of FIG. 2. The storage controller 130 may communicate with the non-volatile memory device 140 to control the non-volatile memory device 140.

Below, an operating method of the storage device 100 according to some embodiments of the present disclosure will be described in detail.

In a first operation ①, the power supply port PP may provide the external power voltage V_ext to each of the power supply circuit 110 and the monitoring circuit 120.

In a second operation ②, the power supply circuit 110 may provide the internal power voltage V_int to the storage controller 130.

In some embodiments, based on the conversion of the external power voltage V_ext, the power supply circuit 110 may generate the internal power voltage V_int including at least one of various driving voltages necessary to drive the storage controller 130.

In a third operation ③, the comparator 121 of the monitoring circuit 120 may provide (e.g. output) the power-on-reset signal POR to the storage controller 130.

In some embodiments, based on determining that the power voltage level of the external power voltage V_ext exceeds the reference voltage level, the comparator 121 may generate the power-on-reset signal POR with the first logical value so as to be output to the storage controller 130.

In a fourth operation ④, the logic circuit 122 of the monitoring circuit 120 may detect the voltage drop in the power-on-reset signal POR.

In some embodiments, the logic circuit 122 may determine whether the voltage drop in the power-on-reset signal POR has occurred, by comparing the power-on-reset signal of the output terminal of the comparator 121 and the power-on-reset signal of the input terminal of the storage controller 130.

In a fifth operation ⑤, the state machine 123 may provide the error detection signal ERR to the storage controller 130.

In some embodiments, the state machine 123 may generate the error detection signal ERR with the seventh logical value in response to detecting the voltage drop in the power-on-reset signal POR.

FIG. 4 is a diagram illustrating a monitoring circuit of FIG. 3 in detail. Referring to FIGS. 3 and 4, the monitoring circuit 120 may include the comparator 121, the logic circuit 122, and the state machine 123.

The comparator 121 may receive the external power voltage V_ext and a reference voltage V_ref. The comparator 121 may generate the power-on-reset signal POR based on the comparison operation of the power voltage level of the external power voltage V_ext and the reference voltage level of the reference voltage V_ref.

The comparator 121 may receive the external power voltage V_ext from the host device 11 through the power supply port PP of FIG. 3. The comparator 121 may receive the reference voltage V_ref from a reference voltage generation device (not illustrated). The reference voltage generation device may be included in the storage device 100 of FIG. 2 and may generate the reference voltage V_ref based on the external power voltage V_ext received through the power supply port PP.

In some embodiments, when the power voltage level exceeds the reference voltage level, the comparator 121 may generate the power-on-reset signal POR with the first logical value. In contrast, when the power voltage level does not exceed the reference voltage level, the comparator 121 may generate the power-on-reset signal POR with the second logical value.

The comparator 121 may output the power-on-reset signal POR to an output terminal OT.

The logic circuit 122 may receive a first electrical signal ES1 from the output terminal OT of the comparator 121. The first electrical signal ES1 which corresponds to the power-on-reset signal POR may indicate the power-on-reset signal POR at the output terminal OT.

The logic circuit 122 may receive a second electrical signal ES2 from an input terminal IT of the storage controller 130. The input terminal IT may indicate a terminal through which the storage controller 130 receives the power-on-reset signal POR output from the comparator 121. The second electrical signal ES2 which corresponds to the power-on-reset signal POR may indicate the power-on-reset signal POR at the input terminal IT.

The second electrical signal ES2 may be different from the first electrical signal ES1. For example, a second voltage level of the second electrical signal ES2 may be lower than a first voltage level of the first electrical signal ES1. That is, the first voltage level may be the high level, and the second voltage level may be the low level.

In some embodiments, a difference of the first electrical signal ES1 and the second electrical signal ES2 (i.e., the voltage drop in the power-on-reset signal POR) may be caused by at least one of the interference by an adjacent electrical element, a high temperature, and a physical impact on a transmission line between the output terminal OT and the input terminal IT,

The logic circuit 122 may generate a monitoring signal MS based on the comparison operation of the first electrical signal ES1 and the second electrical signal ES2.

In some embodiments, the logic circuit 122 may determine whether the first electrical signal ES1 is the same as the second electrical signal ES2. The logic circuit 122 may generate the monitoring signal MS with the fifth logical value, based on determining that the first electrical signal ES1 is the same as the second electrical signal ES2. In contrast, the logic circuit 122 may generate the monitoring signal MS with the sixth logical value, based on determining that the first electrical signal ES1 is different from the second electrical signal ES2.

In some embodiments, the logic circuit 122 may be a NAND gate. In detail, when the third logical value of the first electrical signal ES1 is "1" and the fourth logical value of the second electrical signal ES2 is "0", the NAND gate may generate the monitoring signal MS having "1" as the sixth logical value.

The logic circuit 122 may provide the monitoring signal MS to the state machine 123.

The state machine 123 may receive the monitoring signal MS from the logic circuit 122.

In some embodiments, the state machine 123 may indicate one of a first state S1 and a second state S2. For example, the first state S1 may indicate a normal state (i.e., that an error does not occur in the power-on-reset signal POR). The second state S2 may indicate an error state (i.e., that an error occurs in the power-on-reset signal POR).

In detail, in the first state S1, the state machine 123 may generate the error detection signal ERR with the eighth logical value. In contrast, in the second state S2, the state machine 123 may generate the error detection signal ERR with the seventh logical value.

In response to the monitoring signal MS indicating the sixth logical value, the state machine 123 may change a state to indicate the second state S2 switched from the first state S1. In other words, the state machine 123 may indicate the second state S2 (i.e., the error state), based on detecting the voltage drop in the power-on-reset signal POR.

Until a state reset signal is received from the storage controller 130, the state machine 123 may indicate the second state S2 (i.e., may output the error detection signal ERR with the seventh logical value). The state reset signal may refer to a signal for controlling the state machine 123 such that the state machine 123 is changed as the first state S1 switched from the second state S2 is indicated.

In other words, after the storage controller 130 is shut down by the voltage drop in the power-on-reset signal POR, when the storage controller 130 is again powered on by the internal power voltage and the power-on-reset signal POR where an error does not occur, the state machine 123 continues to provide the error detection signal ERR with the seventh logical value to the storage controller 130. Accordingly, the storage controller 130 may know that the shut-down is caused by the voltage drop in the power-on-reset signal POR, based on the error detection signal ERR.

FIG. 5 is a timing diagram describing a monitoring signal and an error detection signal according to some embodiments of the present disclosure. The monitoring signal MS and the error detection signal ERR will be described based on the external power voltage V_ext, the reference voltage V_ref, the first electrical signal ES1, and the second electrical signal ES2 with reference to FIGS. 4 and 5. In FIG. 5, the horizontal axis represents a time, and the vertical axis represents a voltage level.

At a first point in time t1, the external power voltage V_ext received from a power supply port may exceed the reference voltage V _ref. In FIG. 5, a straight line indicates a change of the external power voltage V_ext over time, but the present disclosure is not limited thereto.

A comparator may output a power-on-reset signal of the low level before the external power voltage V_ext exceeds the reference voltage V_ref and may output the power-on-reset signal of the high level from the first point in time t1 when the external power voltage V_ext exceeds the reference voltage V_ref.

The first electrical signal ES1 may have the low level before the first point in time t1 and may have the high level after the first point in time t1. The first electrical signal ES1 which corresponds to the power-on-reset signal of an output terminal of the comparator may be the same as an output signal of the comparator.

The second electrical signal ES2 may have the low level before the first point in time t1, may have the high level from the first point in time t1 to a second point in time t2, and may have the low level during a time period where an error occurs after the second point in time t2. In one example, in the time period where an error occurs, the second electrical signal ES2 may have a level that is lower than the high level of the second electrical signal ES2 between time t1 and time t2, and higher than the low level of the second electrical signal ES2 before time t1. The time period where the error occurs may indicate a time period where a voltage drop (i.e., an error) occurs in the power-on-reset signal transmitted from the comparator to a storage controller. At the second point in time t2, the storage controller may be shut down.

Because the first electrical signal ES1 and the second electrical signal ES2 are identical before the second point in time t2, the monitoring signal MS may have the low level. However, the monitoring signal MS may have the high level from the second point in time t2 when the first electrical signal ES1 and the second electrical signal ES2 are not identical.

The error detection signal ERR may maintain the low level and may then have the high level from the second point in time t2 when the monitoring signal MS transitions to the high level.

The storage controller may again be powered on based on the external power voltage V_ext received from the power supply port after the storage controller is shut down at the second point in time t2. In other words, the storage controller may again be driven based on the internal power voltage and the power-on-reset signal (in which an error does not occur).

At a third point in time t3, the storage controller may be in a state of being again driven, and the external power voltage V_ext may exceed the reference voltage V_ref. Each of the first electrical signal ES1 and the second electrical signal ES2 may have the high level. Because the first electrical signal ES1 and the second electrical signal ES2 have the same logical value, that is, the high level, the monitoring signal MS may have the low level. However, the error detection signal ERR may have the high level until a state machine receives a state reset signal from the storage controller.

The storage controller again driven may receive the error detection signal ERR with the high level.

FIG. 6 is a table describing a monitoring signal according to some embodiments of the present disclosure. An operation of a logic circuit which generates the monitoring signal MS based on the first electrical signal ES1 and the second electrical signal ES2 will be described with reference to FIGS. 4 and 6.

For convenience of description, an example is given under an assumption that the first logical value of the power-on-reset signal output from a comparator and the sixth logical value of the monitoring signal MS are "0" and the second logical value of the power-on-reset signal output from the comparator and the fifth logical value of the monitoring signal MS are "1".

The logic circuit may detect the voltage drop in the power-on-reset signal based on the comparison operation of the first electrical signal ES1 and the second electrical signal ES2. The logic circuit may generate the monitoring signal MS depending on whether the voltage drop occurs.

When the third logical value of the first electrical signal ES1 is "0", the logic circuit may generate the monitoring signal MS having a logical value of "0" regardless of the fourth logical value of the second electrical signal ES2. That is, the logic circuit may determine that the voltage drop in the power-on-reset signal has not occurred.

When the third logical value of the first electrical signal ES1 is "1" and the fourth logical value of the second electrical signal ES2 is "1", the logic circuit may generate the monitoring signal MS having a logical value of "0". That is, the logic circuit may determine that the voltage drop in the power-on-reset signal has not occurred.

When the third logical value of the first electrical signal ES1 is "1" and the fourth logical value of the second electrical signal ES2 is "0", the logic circuit may generate the monitoring signal MS having a logical value of "1". That is, the logic circuit may determine that the voltage drop in the power-on-reset signal transferred from the comparator to the storage controller has occurred.

FIG. 6 shows only a relationship between the input signals ES1 and ES2 and the output signal MS by using a truth table according to some embodiments, but the present disclosure is not limited thereto. The logic circuit may be an electrical circuit designed to detect the voltage drop in the power-on-reset signal. For example, the logic circuit may be a NAND gate.

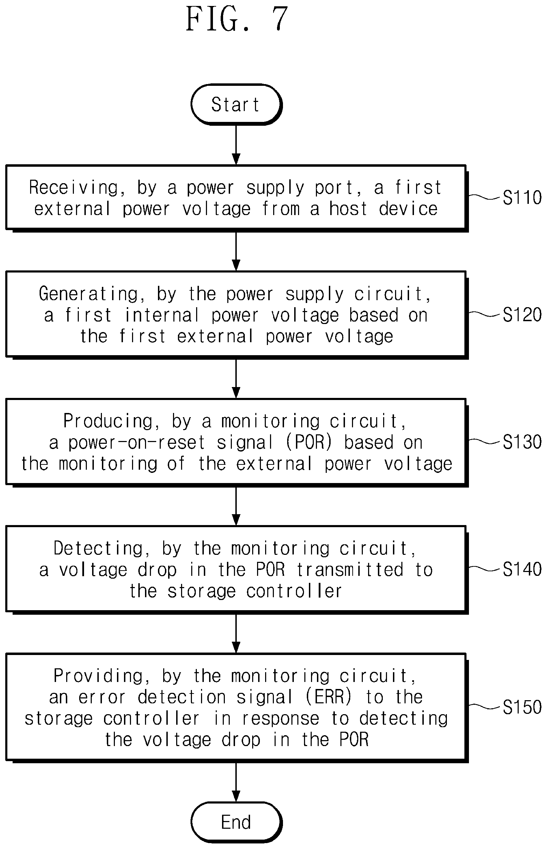

FIG. 7 is a flowchart of an operating method of a storage device according to an embodiment of the present disclosure. The operating method of the storage device 100 of FIG. 3 will be described with reference to FIG. 7. A storage device may include a power supply port, a power supply circuit, a monitoring circuit, and a storage controller. The power supply port, the power supply circuit, the monitoring circuit, and the storage controller may respectively correspond to the power supply port PP, the power supply circuit 110, the monitoring circuit 120, and the storage controller 130 of FIG. 3.

In operation S110, the power supply port may receive a first external power voltage from a host device.

In operation S120, the power supply circuit may generate a first internal power voltage based on the first external power voltage.

In operation S130, the monitoring circuit may generate a first power-on-reset signal POR based on the monitoring of the first external power voltage.

In some embodiments, operation S130 may include determining, by the monitoring circuit, whether a first power voltage level of the first external power voltage exceeds the reference voltage level and generating, by the monitoring circuit, a first power-on-reset signal with a first logical value based on determining that the first power voltage level exceeds the reference voltage level. In this case, the storage controller may be powered on based on the first internal power voltage and the first power-on-reset signal.

In some embodiments, operation S130 may include determining, by the monitoring circuit, whether the first power voltage level of the first external power voltage exceeds the reference voltage level and generating, by the monitoring circuit, the first power-on-reset signal with a second logical value based on determining that the first power voltage level does not exceed the reference voltage level. In this case, even though the internal power voltage is received, because the first power-on-reset signal has the second logical value, the storage controller may not be powered on.

In operation S140, the monitoring circuit may detect a voltage drop in the first power-on-reset signal POR.

In some embodiments, operation S140 may include receiving, by the monitoring circuit, a first electrical signal through an output terminal of the monitoring circuit, receiving, by the monitoring circuit, a second electrical signal through an input terminal of the storage controller, and detecting, by the monitoring circuit, the voltage drop in the first power-on-reset signal POR based on a comparison operation of the first electrical signal and the second electrical signal.

For example, the output terminal of the monitoring circuit may correspond to the output terminal OT of the comparator 121 of the monitoring circuit 120 of FIG. 4. The first electrical signal may correspond to the first power-on-reset signal of the output terminal of the monitoring circuit. Also, the input terminal of the storage controller which is a terminal of receiving the first power-on-reset signal may correspond to the input terminal IT of the storage controller 130 of FIG. 4. The second electrical signal may correspond to the first power-on-reset signal of the input terminal of the storage controller. The second electrical signal may be different from the first electrical signal due to various causes.

In some embodiments, the detecting of the voltage drop in the first power-on-reset signal POR, by the monitoring circuit, based on the comparison operation of the first electrical signal and the second electrical signal may include determining, by the monitoring circuit, whether the first logical value of the first electrical signal is the same as the second logical value of the second electrical signal, and generating a monitoring signal with a sixth logical value based on determining that the first logical value and the second logical value are different.

For example, the monitoring signal with the sixth logical value may correspond to that the voltage drop in the first power-on-reset signal occurs.

In some embodiments, that the first electrical signal and the second electrical signal are different (i.e., the voltage drop in the first power-on-reset signal POR) may be caused by at least one of the interference by an adjacent electrical element, a high temperature, and a physical impact on a transmission line through which the first power-on-reset signal POR is transmitted from the monitoring circuit to the storage controller.

In detail, the physical impact may be applied to the transmission line by a foreign material in the storage device, the transmission line may be exposed to the high temperature depending to a change of an internal or external temperature of the storage device, or the electrical interference may be caused on the transmission line by any other electrical elements (e.g., any other input/output lines) in the storage device, which are adjacent to the transmission line.

In operation S150, the monitoring circuit may provide the error detection signal ERR to the storage controller in response to detecting the voltage drop in the first power-on-reset signal POR.

In some embodiments, operation S150 may include generating, by the monitoring circuit, the error detection signal ERR with a seventh logical value in response to that the monitoring signal has the sixth logical value, and providing, by the monitoring circuit, the error detection signal ERR with the seventh logical value to the storage controller until a state reset signal is received from the storage controller.

For example, when the monitoring circuit starts to output the error detection signal ERR with the seventh logical value in response to that the monitoring signal has the sixth logical value, the monitoring circuit may output the error detection signal ERR with the seventh logical value to the storage controller, regardless of the monitoring signal, until the state reset signal is received from the storage controller. This will be described in detail with reference to FIG. 9.

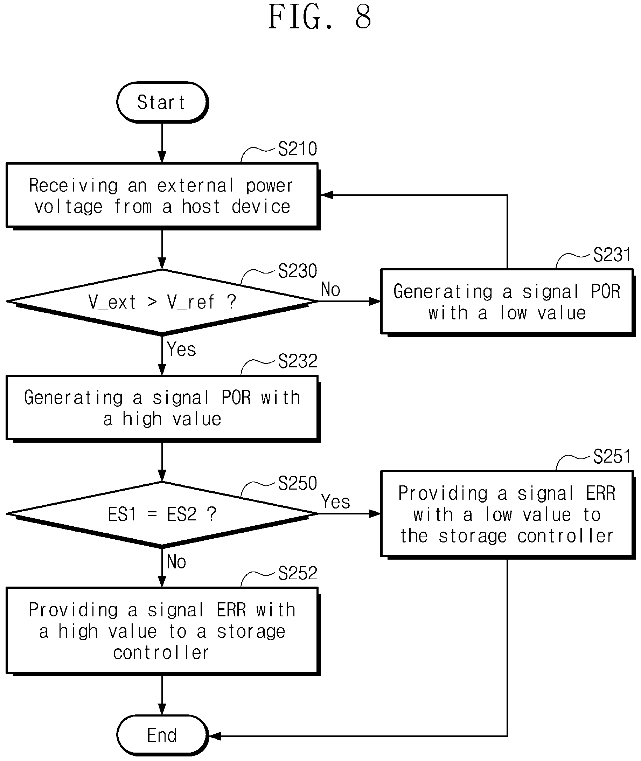

FIG. 8 is a flowchart of an operating method of a storage device according to some embodiments of the present disclosure. The operating method of the storage device 100 of FIG. 3 will be described in detail with reference to FIG. 8 in terms of a comparison operation.

In operation S210, a storage device may receive a first external power voltage from a host device through a power supply port.

In operation S230, the storage device may determine whether a first power voltage level of the first external power voltage (V_ext) exceeds a reference voltage level of a reference voltage (V_ref). The storage device may perform operation S231 based on determining that the first power voltage level does not exceed the reference voltage level. The storage device may perform operation S232 based on determining that the first power voltage level exceeds the reference voltage level.

In operation S231, the storage device may generate a first power-on-reset signal POR with the low level in response to determining that the first power voltage level does not exceed the reference voltage level. Afterwards, the storage device may again perform operation S210.

In operation S232, the storage device may generate the first power-on-reset signal POR with the high level in response to determining that the first power voltage level exceeds the reference voltage level.

In operation S250, the logic circuit 122 may determine whether the first electrical signal ES1 is the same as the second electrical signal ES2. The storage device may perform operation S251 based on determining that the first electrical signal ES1 is the same as the second electrical signal ES2. The storage device may perform operation S252 based on determining that the first electrical signal ES1 is different from the second electrical signal ES2.

In operation S251, the storage device may provide the error detection signal ERR with the low level to the storage controller.

In operation S252, the storage device may provide the error detection signal ERR with the high level to the storage controller.

FIG. 9 is a flowchart describing an operating method of a storage controller after the storage controller is shut down, according to some embodiments of the present disclosure. An operation of the storage controller, which is performed after the storage controller is shut down by the voltage drop of the first power-on-reset signal POR, will be described with reference to FIG. 9. The storage controller may correspond to the storage controller 130 of FIG. 3.

After the storage controller is shut down, the power supply port may receive a second external power voltage from a host device.

A power supply circuit may generate a second internal power voltage based on the second external power voltage and may provide the second internal power voltage to the storage controller.

The monitoring circuit may generate a second power-on-reset signal POR based on the monitoring of the second external power voltage and may provide the second power-on-reset signal POR to the storage controller.

For convenience of description, the second external power voltage, the second internal power voltage, and the second power-on-reset signal POR are signals identical in kind to the external power voltage, the internal power voltage, and the power-on-reset signal described above and are defined as being distinguished from the first external power voltage, the first internal power voltage, and the first power-on-reset signal based on signal-generated times.

In operation S310, the storage controller may be again powered on (or may be again be driven, or may be re-powered) based on the second internal power voltage and the second power-on-reset signal POR. In detail, the storage controller may be powered on based on the second internal power voltage in response to the second power-on-reset signal POR with the first logical value.

In operation S320, the storage controller may receive the error detection signal ERR from a monitoring circuit. In this case, the error detection signal ERR which corresponds to the error occurrence of the first power-on-reset signal may have the high level.

In operation S330, the storage controller may log error detection information based on the error detection signal ERR. The error detection information may indicate that an error occurs in the process where the first power-on-reset signal is provided to the storage controller.

In some embodiments, the storage controller may store the error detection information in a read only memory device (e.g., a ROM) in the storage controller.

In some embodiments, the storage controller may provide the logged error detection information to the communication port CP of FIG. 2 depending on a request of the host device.

In some embodiments, as another example, the storage controller may further include a debugging device. The storage controller may log the error detection information in the debugging device. The debugging device may be implemented by firmware which executes a debugging algorithm debugging the error caused when the power is supplied to the storage device.

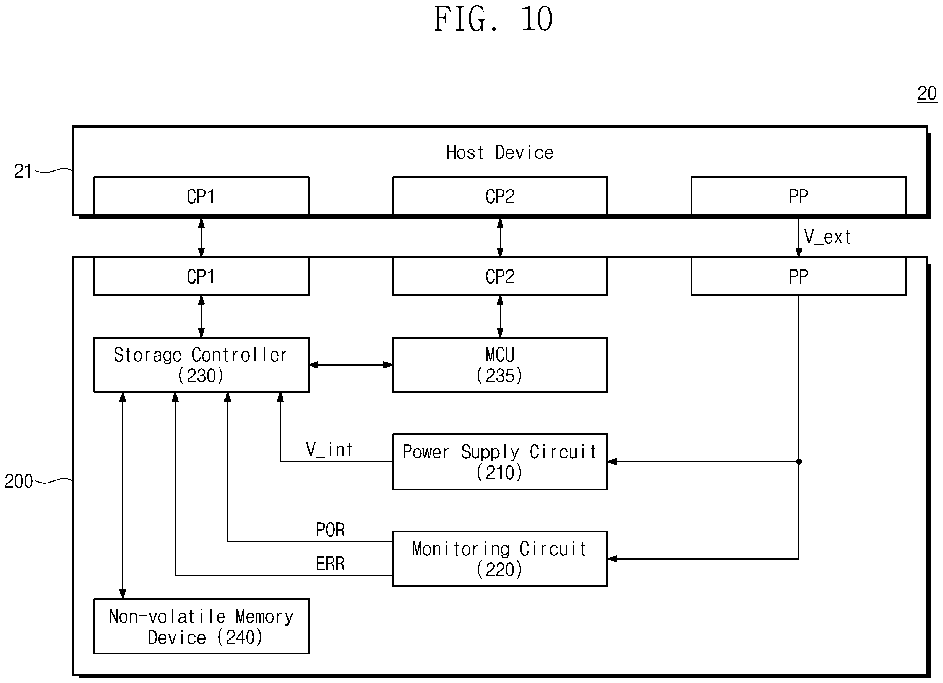

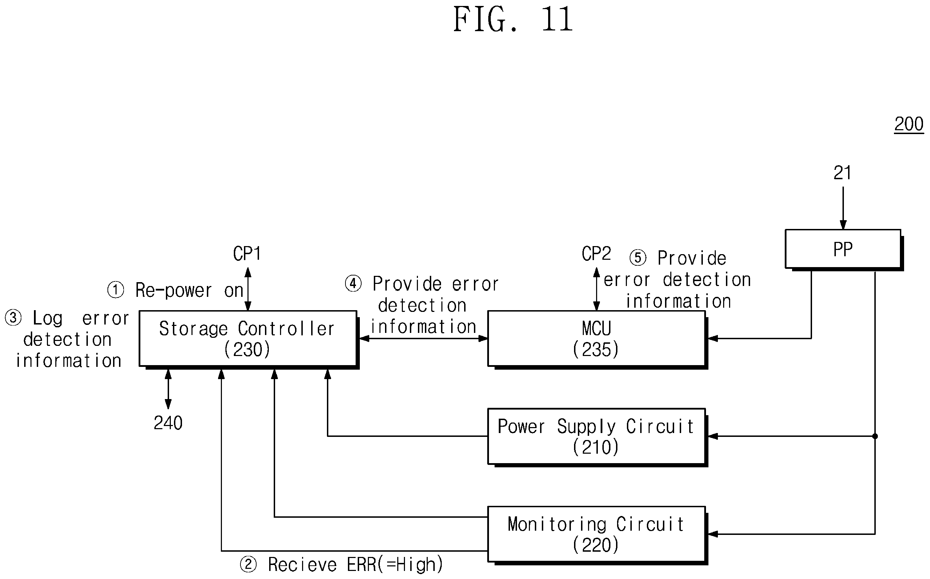

In some embodiments, the storage device may provide the logged error detection information to a micro controller unit (MCU). The MCU may provide the error detection information to a host. This will be described in detail with reference to FIGS. 10 and 11.

FIG. 10 is a block diagram of a storage system according to some embodiments of the present disclosure. A storage system 20 which further includes a micro controller unit (MCU) is illustrated in FIG. 10. Referring to FIG. 10, the storage system 20 may include a host device 21 and a storage device 200.

The host device 21 may include a first communication port CP1, a second communication port CP2, and a power supply port PP. The host device 21, the first communication port CP1, and the power supply port PP may respectively correspond to the host device 11, the communication port CP, and the power supply port PP of FIG. 2.

The storage device 200 may include a first communication port CP1, a second communication port CP2, a power supply port PP, a power supply circuit 210, a monitoring circuit 220, a storage controller 230, an MCU 235, and a non-volatile memory device 240. The first communication port CP1, the power supply port PP, the power supply circuit 210, the monitoring circuit 220, the storage controller 230, and the non-volatile memory device 240 may correspond to the communication port CP, the power supply port PP, the power supply circuit 110, the monitoring circuit 120, the storage controller 130, and the non-volatile memory device 140.

The storage controller 230 and the host device 21 may communicate through the first communication ports CP1. For example, the storage controller 230 may exchange data with the host device 21.

In some embodiments, the first communication ports CP1 may use the in-band channel. For example, the first communication port CP1 may be a PCIe port.

The MCU 235 and the host device 21 may communicate through the second communication ports CP2. For example, the MCU 235 may provide error detection information to the second communication port CP2.

In some embodiments, the second communication ports CP2 may use the out-of-band channel. For example, the second communication port CP2 may be a system management bus (SMBUS) port.

The power supply circuit 210 may generate the internal power voltage V_int based on the external power voltage V_ext received from the power supply port PP and may provide the internal power voltage V_int to the storage controller 230.

The monitoring circuit 220 may generate the power-on-reset signal POR based on the monitoring of the external power voltage V_ext and may provide the power-on-reset signal POR to the storage controller 230. The monitoring circuit 220 may detect the voltage drop of the power-on-reset signal POR and may provide the error detection signal ERR to the storage controller 230.

The storage controller 230 may be powered off based on the voltage drop of the power-on-reset signal POR and may then be again driven by an internal power voltage again provided and a power-on-reset signal.

The storage controller 230 again driven may receive the error detection signal ERR from the monitoring circuit 220.

The storage controller 230 may log error detection information in response to that the error detection signal ERR has the high level.

The storage controller 230 may provide the logged error detection information to the MCU 235.

The MCU 235 may receive the error detection information from the storage controller 230. The MCU 235 may provide the error detection information to the host device 21 through the second communication port CP2.

FIG. 11 is a diagram describing an operating method of a storage device after a storage controller of FIG. 10 is again driven. Referring to FIGS. 10 and 11, the storage device 200 may include the power supply port PP, the first communication port CP1, the second communication port CP2, the power supply circuit 210, the monitoring circuit 220, the storage controller 230, and the MCU 235. In order to achieve a brief description, the description given above for FIG. 10 is not repeated where redundant.

Below, an operating method of the storage device 200 according to some embodiments of the present disclosure will be described in detail.

In a first operation ①, the storage controller 230 may be again powered on. That is, a storage controller may be shut down by a voltage drop (i.e., an error) in a power-on-reset signal and may be again powered on (e.g. may be re-powered) based on an internal power voltage and a power-on-reset signal.

In a second operation ②, the storage controller 230 may receive the error detection signal ERR with the high level from the monitoring circuit 220.

In a third operation ③, the storage controller 230 may log error detection information in response to the error detection signal ERR having the high level.

In a fourth operation (4), the storage controller 230 may provide the logged error detection information to the MCU 235. Thus, a cause of a storage controller shut-down is known.

In a fifth operation ⑤, the MCU 235 may provide the error detection information to the second communication port CP2.

In detail, the MCU 235 may receive the error detection information from the storage controller 230. The MCU 235 may provide the error detection information to a host device through the second communication port CP2 depending on a request of the host device.

According to an embodiment of the present disclosure, a storage device detecting an error in a power-on-reset signal and an operating method thereof are provided.

Also, when an error occurs in a power-on-reset signal controlling the power supply to a storage controller, even though the storage controller is shut down, the notification indicating that the error occurs in the power-on-reset signal may be provided from the outside of the storage controller to the storage controller. Accordingly, a storage device capable of detecting an error in a power-on-reset signal is provided.

Embodiments are set out in the following clauses:
Clause 1. A storage device comprising: a memory device; a power supply port configured to receive a first external power voltage from a host device; a power supply circuit configured to: receive the first external power voltage from the power supply port, and generate a first internal power voltage based on the first external power voltage; a monitoring circuit configured to: receive the first external power voltage from the power supply port, and generate a first power-on-reset signal based on monitoring the first external power voltage; and a storage controller configured to control the memory device, wherein the storage controller is driven based on the first internal power voltage and the first power-on-reset signal, and wherein the monitoring circuit is further configured to: detect a voltage drop in the first power-on-reset signal transmitted from the monitoring circuit to the storage controller, and provide an error detection signal to the storage controller in response to detecting the voltage drop, whereby a shut-down cause of the storage controller can be detected, and wherein the voltage drop is the shut-down cause of the storage controller.
Clause 2. The storage device of clause 1, wherein the monitoring circuit comprises: a comparator configured to: determine whether a first power voltage level of the first external power voltage exceeds a reference voltage level, generate the first power-on-reset signal with a first logical value based on determining that the first power voltage level exceeds the reference voltage level, and generate the first power-on-reset signal with a second logical value different from the first logical value based on determining that the first power voltage level does not exceed the reference voltage level; and a logic circuit configured to: receive a first electrical signal corresponding to the first power-on-reset signal through an output terminal of the comparator, receive a second electrical signal corresponding to the first power-on-reset signal through an input terminal of the storage controller, and detect the voltage drop based on a comparison operation of the first electrical signal and the second electrical signal.
Clause 3. The storage device of clause 2, wherein the logic circuit is further configured to: determine whether a third logical value of the first electrical signal is the same as a fourth logical value of the second electrical signal; output a monitoring signal with a fifth logical value, based on determining that the third logical value is the same as the fourth logical value; and output the monitoring signal with a sixth logical value different from the fifth logical value, based on determining that the third logical value is different from the fourth logical value.
Clause 4. The storage device of clause 2 or 3, wherein the logic circuit is a NAND gate.
Clause 5. The storage device of clause 2, 3 or 4, wherein the monitoring circuit further comprises a state machine configured to provide the error detection signal with a seventh logical value to the storage controller, until a state reset signal is received from the storage controller, in response to the logic circuit detecting the voltage drop.
Clause 6. The storage device of any preceding clause, wherein the monitoring circuit is further configured to: provide the error detection signal with a seventh logical value to the storage controller, based on determining that the voltage drop in the first power-on-reset signal has occurred; and provide the error detection signal with an eighth logical value different from the seventh logical value to the storage controller, based on determining that the voltage drop in the first power-on-reset signal has not occurred.
Clause 7. The storage device of any preceding clause, wherein the voltage drop in the first power-on-reset signal is caused by at least one of an interference by an adjacent electrical element, a high temperature, and a physical impact on a transmission line through which the first power-on-reset signal is transmitted from the monitoring circuit to the storage controller.
Clause 8. The storage device of any preceding clause, wherein, after the storage controller is powered off by the voltage drop in the first power-on-reset signal, the power supply port receives a second external power voltage from the host device, wherein the power supply circuit generates a second internal power voltage based on the second external power voltage, wherein the monitoring circuit is further configured to generate a second power-on-reset signal based on monitoring the second external power voltage, and wherein the storage controller is further configured to: be again driven based on the second internal power voltage and the second power-on-reset signal, and receive the error detection signal from the monitoring circuit, after again driven.
Clause 9. The storage device of any preceding clause, wherein the storage controller is further configured to: based on the storage controller being powered off by the voltage drop in the first power-on-reset signal and is then again driven, receive the error detection signal from the monitoring circuit; and log error detection information indicating the voltage drop in the first power-on-reset signal, based on the error detection signal, wherein the error detection information indicates the shut-down cause.
Clause 10. The storage device of clause 9, further comprising: a first communication port configured to communicate by using an in-band channel, wherein the storage controller is further configured to provide the error detection information to the host device through the first communication port.
Clause 11. The storage device of clause 9 or 10, further comprising: a second communication port configured to communicate by using an out-of-band channel; and a micro controller unit (MCU) configured to receive the error detection information from the storage controller and to provide the error detection information to the host device through the second communication port.
Clause 12. A method performed by a storage device, wherein the storage device comprises a memory device, a power supply port, a power supply circuit, a storage controller, and a monitoring circuit, the method comprising: receiving, by the power supply port, a first external power voltage from a host device; generating, by the power supply circuit, a first internal power voltage based on the first external power voltage; generating, by the monitoring circuit, a first power-on-reset signal based on monitoring the first external power voltage; detecting, by the monitoring circuit, a voltage drop in the first power-on-reset signal transmitted from the monitoring circuit to the storage controller; and providing, by the monitoring circuit, an error detection signal to the storage controller in response to detecting the voltage drop, whereby a shut-down cause of the storage controller can be detected, the voltage drop is the shut-down cause of the storage controller, and the error detection signal corresponds to the shut-down cause.
Clause 13. The method of clause 12, wherein the generating of the first power-on-reset signal, by the monitoring circuit, based on the monitoring of the first external power voltage comprises: determining, by the monitoring circuit, whether a first power voltage level of the first external power voltage exceeds a reference voltage level; and generating, by the monitoring circuit, the first power-on-reset signal with a first logical value, based on determining that the first power voltage level exceeds the reference voltage level.
Clause 14. The method of clause 12 or 13, wherein the detecting of the voltage drop in the first power-on-reset signal transmitted from the monitoring circuit to the storage controller by the monitoring circuit comprises: receiving, by the monitoring circuit, a first electrical signal corresponding to the first power-on-reset signal through an output terminal of the monitoring circuit; receiving, by the monitoring circuit, a second electrical signal corresponding to the first power-on-reset signal through an input terminal of the storage controller; and detecting, by the monitoring circuit, the voltage drop based on a comparison operation of the first electrical signal and the second electrical signal.
Clause 15. The method of clause 14, wherein the detecting of the voltage drop, by the monitoring circuit, based on the comparison operation of the first electrical signal and the second electrical signal comprises: determining, by the monitoring circuit, whether a third logical value of the first electrical signal is the same as a fourth logical value of the second electrical signal; and generating, by the monitoring circuit, a monitoring signal with a sixth logical value, based on determining that the third logical value is different from the fourth logical value.
Clause 16. The method of any of clauses 12 to 15, wherein the providing of the error detection signal to the storage controller, by the monitoring circuit, in response to the detecting of the voltage drop comprises: generating, by the monitoring circuit, the error detection signal with a seventh logical value in response to the detecting of the voltage drop; and outputting, by the monitoring circuit, the error detection signal with the seventh logical value to the storage controller until a state reset signal is received from the storage controller.
Clause 17. The method of any of clauses 12 to 16, further comprising: when the storage controller is powered off by the voltage drop and is again driven, receiving the error detection signal from the monitoring circuit; and logging, by the storage controller, error detection information indicating the voltage drop in the first power-on-reset signal, based on the error detection signal, wherein the error detection information indicates the shut-down cause.
Clause 18. The method of any of clauses 12 to 17, further comprising: receiving, by the power supply port, a second external power voltage; generating, by the power supply circuit, a second internal power voltage based on the second external power voltage; and generating, by the monitoring circuit, a second power-on-reset signal based on monitoring the second external power voltage, wherein the storage device is again driven based on the second internal power voltage and the second power-on-reset signal, and wherein the storage device receives the error detection signal from the monitoring circuit.
Clause 19. The method of any of clauses 12 to 18, wherein the voltage drop in the first power-on-reset signal is caused by at least one of an interference by an adjacent electrical element, a high temperature, and a physical impact on a transmission line through which the first power-on-reset signal is transmitted from the monitoring circuit to the storage controller.
Clause 20. A storage device comprising: a memory device; a power supply port configured to receive a first external power voltage from a host device; a communication port configured to communicate with the host device; a power supply circuit configured to receive the first external power voltage from the power supply port and to generate a first internal power voltage based on the first external power voltage; a monitoring circuit configured to receive the first external power voltage from the power supply port and to generate a first power-on-reset signal based on monitoring the first external power voltage; a storage controller, wherein the storage controller is driven based on the first internal power voltage and the first power-on-reset signal; and a micro controller unit (MCU) configured to communicate with the host device by using the communication port, wherein the monitoring circuit is configured to: detect a voltage drop in the first power-on-reset signal transmitted from the monitoring circuit to the storage controller, and provide an error detection signal to the storage controller in response to detecting the voltage drop, wherein the storage controller is further configured to log error detection information based on the error detection signal, whereby a shut-down cause of the storage controller can be detected, and wherein the voltage drop is the shut-down cause of the storage controller, and wherein the MCU is further configured to provide the error detection information received from the storage controller to the communication port.

While the present disclosure has been described with reference to embodiments thereof, it will be apparent to those of ordinary skill in the art that various changes and modifications may be made thereto without departing from the scope of the present disclosure as set forth in the following claims.

## Claims

1. A storage device comprising:
a memory device;
a power supply port configured to receive a first external power voltage from a host device;
a power supply circuit configured to:
receive the first external power voltage from the power supply port, and
generate a first internal power voltage based on the first external power voltage;
a monitoring circuit configured to:
receive the first external power voltage from the power supply port, and
generate a first power-on-reset signal based on monitoring the first external power voltage; and
a storage controller configured to control the memory device,
wherein the storage controller is driven based on the first internal power voltage and the first power-on-reset signal, and
wherein the monitoring circuit is further configured to:
detect a voltage drop in the first power-on-reset signal transmitted from the monitoring circuit to the storage controller, and
provide an error detection signal to the storage controller in response to detecting the voltage drop, whereby a shut-down cause of the storage controller can be detected, and wherein the voltage drop is the shut-down cause of the storage controller.

2. The storage device of claim 1, wherein the monitoring circuit comprises:
a comparator configured to:
determine whether a first power voltage level of the first external power voltage exceeds a reference voltage level,
generate the first power-on-reset signal with a first logical value based on determining that the first power voltage level exceeds the reference voltage level, and
generate the first power-on-reset signal with a second logical value different from the first logical value based on determining that the first power voltage level does not exceed the reference voltage level; and
a logic circuit configured to:
receive a first electrical signal corresponding to the first power-on-reset signal through an output terminal of the comparator,
receive a second electrical signal corresponding to the first power-on-reset signal through an input terminal of the storage controller, and
detect the voltage drop based on a comparison operation of the first electrical signal and the second electrical signal.

3. The storage device of claim 2, wherein the logic circuit is further configured to:
determine whether a third logical value of the first electrical signal is the same as a fourth logical value of the second electrical signal;
output a monitoring signal with a fifth logical value, based on determining that the third logical value is the same as the fourth logical value; and
output the monitoring signal with a sixth logical value different from the fifth logical value, based on determining that the third logical value is different from the fourth logical value.

4. The storage device of claim 2 or 3, wherein the logic circuit is a NAND gate.

5. The storage device of claim 2, 3 or 4, wherein the monitoring circuit further comprises a state machine configured to provide the error detection signal with a seventh logical value to the storage controller, until a state reset signal is received from the storage controller, in response to the logic circuit detecting the voltage drop.

6. The storage device of any preceding claim, wherein the monitoring circuit is further configured to:
provide the error detection signal with a seventh logical value to the storage controller, based on determining that the voltage drop in the first power-on-reset signal has occurred; and
provide the error detection signal with an eighth logical value different from the seventh logical value to the storage controller, based on determining that the voltage drop in the first power-on-reset signal has not occurred.

7. The storage device of any preceding claim, wherein the voltage drop in the first power-on-reset signal is caused by at least one of an interference by an adjacent electrical element, a high temperature, and a physical impact on a transmission line through which the first power-on-reset signal is transmitted from the monitoring circuit to the storage controller.

8. The storage device of any preceding claim, wherein, after the storage controller is powered off by the voltage drop in the first power-on-reset signal, the power supply port receives a second external power voltage from the host device,
wherein the power supply circuit generates a second internal power voltage based on the second external power voltage,
wherein the monitoring circuit is further configured to generate a second power-on-reset signal based on monitoring the second external power voltage, and
wherein the storage controller is further configured to:
be again driven based on the second internal power voltage and the second power-on-reset signal, and
receive the error detection signal from the monitoring circuit, after again driven.

9. The storage device of any preceding claim, wherein the storage controller is further configured to:
based on the storage controller being powered off by the voltage drop in the first power-on-reset signal and is then again driven, receive the error detection signal from the monitoring circuit; and
log error detection information indicating the voltage drop in the first power-on-reset signal, based on the error detection signal, wherein the error detection information indicates the shut-down cause.

10. The storage device of claim 9, further comprising:
a first communication port configured to communicate by using an in-band channel,
wherein the storage controller is further configured to provide the error detection information to the host device through the first communication port.

11. The storage device of claim 9 or 10, further comprising:
a second communication port configured to communicate by using an out-of-band channel; and
a micro controller unit (MCU) configured to receive the error detection information from the storage controller and to provide the error detection information to the host device through the second communication port.

12. A method performed by a storage device, wherein the storage device comprises a memory device, a power supply port, a power supply circuit, a storage controller, and a monitoring circuit, the method comprising:
receiving, by the power supply port, a first external power voltage from a host device;
generating, by the power supply circuit, a first internal power voltage based on the first external power voltage;
generating, by the monitoring circuit, a first power-on-reset signal based on monitoring the first external power voltage;
detecting, by the monitoring circuit, a voltage drop in the first power-on-reset signal transmitted from the monitoring circuit to the storage controller; and
providing, by the monitoring circuit, an error detection signal to the storage controller in response to detecting the voltage drop, whereby a shut-down cause of the storage controller can be detected, the voltage drop is the shut-down cause of the storage controller, and the error detection signal corresponds to the shut-down cause.

13. The method of claim 12, wherein the generating of the first power-on-reset signal, by the monitoring circuit, based on the monitoring of the first external power voltage comprises:
determining, by the monitoring circuit, whether a first power voltage level of the first external power voltage exceeds a reference voltage level; and
generating, by the monitoring circuit, the first power-on-reset signal with a first logical value, based on determining that the first power voltage level exceeds the reference voltage level.

14. The method of claim 12 or 13, wherein the detecting of the voltage drop in the first power-on-reset signal transmitted from the monitoring circuit to the storage controller by the monitoring circuit comprises:
receiving, by the monitoring circuit, a first electrical signal corresponding to the first power-on-reset signal through an output terminal of the monitoring circuit;
receiving, by the monitoring circuit, a second electrical signal corresponding to the first power-on-reset signal through an input terminal of the storage controller; and
detecting, by the monitoring circuit, the voltage drop based on a comparison operation of the first electrical signal and the second electrical signal.

15. The method of claim 14, wherein the detecting of the voltage drop, by the monitoring circuit, based on the comparison operation of the first electrical signal and the second electrical signal comprises:
determining, by the monitoring circuit, whether a third logical value of the first electrical signal is the same as a fourth logical value of the second electrical signal; and
generating, by the monitoring circuit, a monitoring signal with a sixth logical value, based on determining that the third logical value is different from the fourth logical value.
